# EUROPÄISCHE PATENTSCHRIFT

(11) **EP 0 903 972 B1**
(45) Veröffentlichungstag und Bekanntmachung des Hinweises auf die Patenterteilung: **24.11.2004**
(21) Anmeldenummer: 98114271.4
(22) Anmeldetag: 30.07.1998
(51) Int. Cl.: H05K 7/20

(54) **Vorrichtung zum Austausch von Wärmeenergie zwischen einem Gehäuseinnenraum und einer Umgebung**
Heat exchange device between inside a housing and environment
Dispositif échangeur de chaleur entre l'intérieur d'une enceinte et l'environnement

(30) Priorität: 17.09.1997 DE 29716682 U
(43) Veröffentlichungstag der Anmeldung: 24.03.1999
(73) Patentinhaber: Pfannenberg GmbH, 21035 Hamburg (DE)
(72) Erfinder: Knoblauch, Harald, 21129 Hamburg (DE)
(74) Vertreter: Richter, Werdermann, Gerbaulet & Hofmann

(56) Entgegenhaltungen:
- GB-A- 2 277 767
- US-A- 3 559 728
- US-A- 4 352 008
- US-A- 4 582 130

## Beschreibung

Die Erfindung betrifft eine Vorrichtung zum Austausch von Wärmeenergie zwischen einem Innenraum eines Gehäuses, insbesondere für ein Telekommunikationsgerät, und einer Umgebung gemäß dem Oberbegriff des Anspruchs 1.

Das Gehäuse einer elektrischen Vorrichtung, beispielsweise ein Übertragungsschrank mit einer darin enthaltenen Funkausrüstung für ein mobiles Telefonsystem, beinhaltet insbesondere elektrische Komponenten, welche Abwärme erzeugen. Diese Abwärme ist zur Vermeidung einer Überhitzung der elektrischen Geräte abzuführen.

Da es sich bei derartigen Gehäusen üblicherweise um luftdicht bzw. hermetisch abgeschlossene Behälter handelt, ist eine Verwendung eines einfachen Abluftventilators nicht möglich.

Durch die GB-A- 2 284 659 ist eine Vorrichtung zum Austausch von Wärmeenergie zwischen einem Innenraum eines Gehäuses und einer Umgebung bekannt, wobei diese Vorrichtung einen Wärmetauscherblock mit wenigstens zwei voneinander getrennten und miteinander in Wärmeenergie übertragendem Kontakt stehenden Fluidleitungssystem umfasst, wobei ein erstes Fluidleitungssystem mit dem Gehäuseinnenraum und ein zweites Fluidleitungssystem it der Umgebung verbunden ist. Jedem Fluidleitungssystem ist eine Fluidpumpe zum Fördern eines ersten Arbeitsfluids im ersten Fluidleitungssystem und ein zweites Arbeitsfluid im zweiten Fluidleitungssystem zugeordnet. Dabei sind drehzahlgeregelte, mit einem Temperatursensor verbundene Ventilatoren vorgesehen, die jedoch bei Erreichung eines vorgebbaren Levels, beispielsweise 15° C entweder in der Drehzahl reduziert oder gemeinsam komplett außer Betrieb genommen werden.

Durch die US-A-4,582,130 ist ein Wärmetauscher für ein Elektronikgehäuse mit einem Faltflächenprofil, bei dem auf beiden Seiten abwechselnd jede zweite Falte gas- oder staubdicht durch eine Abdeckung verschlossen ist, bekannt. Mit einem derartigen Luft/Luft-Wärmetauscher soll die Abwärme aus dem Inneren eines Elektronikgehäuse nach außen geleitet werden, wenn das Elektronikgehäuse staubdicht geschlossen ist. Zur Erleichterung der Herstellung des Faltflächenprofils sind die Abdeckungen vollständig auf die Falten geformt. Ein derartiges Faltflächenprofil, bei dem die Falten und die Abdeckungen ein einziges Bauteil bilden, wird vorzugsweise als tiefgezogenes Teil hergestellt, so dass das Bauteil aus Kunststoff gefertigt werden kann. Danach besteht der Wärmeaustauscher für ein Elektronikgehäuse aus einem Faltflächenprofil mit einer Tiefe jeder Falte des Faltflächenprofils von ungefähr dem Sechsfachen der Breite jeder Falte des Faltflächenprofils, um dadurch das Formen in einem einzigen Tiefziehvorgang aus einem einzigen Kunststoffstück zu erleichtern, wobei abwechselnd auf beiden Seiten jede zweite Falte gasdicht durch eine Abdeckung verschlossen ist. Auch die Abdeckung ist aus dem einzigen Kunststoffstück auf die Falten des Faltflächenprofils geformt. Der Wärmeaustauscher ist dabei so ausgebildet, dass an der Seitenfläche des Faltflächenprofils eine Tragplatte angebracht ist, die über das Faltflächenprofil hinausragt und gasdicht mit der Seitenwand des Deckels und der Seitenwand der Gehäuseplatte zusammengefügt ist. Wesentlich ist die gas- oder staubdichte Verbindung der Platte mit dem Faltflächenprofil und den Seitenwänden. Die Seitenwand ist dabei abnehmbar und gasdicht an der Platte befestigt, beispielsweise mit einer Dichtung, um es möglich zu machen, den Deckel abzunehmen, um die Falten zu reinigen. Öffnungen, die im Bereich der Abdeckungen über den Falten angeordnet sind, sind in der Tragplatte vorgesehen. Schließlich wird Luft für den zweiten Strömungsweg durch eine andere Öffnung zugeführt. Mit dem Deckel und der Tragplatte wird ein Behältnis gebaut, in dem ein Ventilator für die Luftzirkulation angeordnet wird. Ein ähnliches Behältnis wird durch das Gehäuseteil mit der Tragplatte gebildet. In diesem Gehäuse ist ein Ventilator für den anderen Luftkreislauf eingebaut, sowie seine elektrischen Anschlüsse. Für beide Luftkreisläufe ist vorausgesetzt, dass die Öffnungen in der Tragplatte ins Innere des Gehäuses münden. Danach wird eine Vorrichtung zum Austausch von Wärmeenergie zwischen einem Innenraum eines Gehäuses und einer Umgebung mit wenigstens zwei voneinander getrennten und miteinander in Wärmeenergie übertragenden Kontakt stehenden Fluidleitungssystemen erhalten.

Danach ist ein erstes Fluidleitungssystem mit dem Gehäuseinnenraum und ein zweites Fluidleitungssystem mit der Umgebung verbunden. Der bekannte Wärmeaustauscher weist jedoch keine Steuereinrichtung auf, die die Drehzahl der Ventilatoren steuert, um die Innentemperatur in dem Gehäuse zu steuern und um diese auf eine vorgegebene Temperatur zu halten.

Durch die GB-A-2 277 767 ist eine Telekommunikationsfeststation bekannt, die einen kastenförmigen Körper mit einer Tür umfasst, die durch Scharniere schwenkbar angebracht ist. Die Tür weist mit Luftschlitzen versehene Platten auf, zwei Ventilatoren und einen Wärmetauscher (optional eine Heizung oder Kühleinheit), so dass die Tür die Geräte zur Regulierung der Umgebungsbedingungen in der Feststation enthält. Dies bietet die Möglichkeit, Feststationen mit Standardkörpern zu schaffen, bei denen jede einzelne Feststation so ausgestattet ist, dass sie bestimmten Umgebungsbedingungen (beispielsweise extremer Wärme oder extremer Kälte) gerecht wird, indem der Körper mit einer geeigneten Tür versehen wird. Der Aufbau dieser Feststation ist derart, dass die Feststation einen kastenförmigen Körper mit einer Vorderöffnung aufweist, die mit einer Tür verschließbar ist, die um eine vertikale Achse mit Hilfe dreier voneinander beabstandeter Scharniere schwenkbar am Körper angebracht ist. Ein Sicherheitsschloss sichert die Tür bei geschlossener Stellung.

Die Lufttemperatur in der Feststation wird durch in oder auf der Tür angebrachte Geräte reguliert, während der Körper frei von jeglichem Gerät zur Regulierung von Umgebungsbedingungen ist. Insbesondere verfügt die Tür über Platten mit Luftschlitzen und zwei Ventilatoren, die beide auf der Innenseite der Tür angebracht sind, wobei einer der Ventilatoren direkt hinter der Platte mit Luftschlitzen angeordnet ist. Ein Wabenwärmetauscher ist ebenfalls an der Innenseite der Tür angebracht.

Die Schnittstelle Tür/Körper ist mit einer Umgebungsdichtung und einer Dichtung gegen elektromagnetische Strahlung ausgestattet. Zuleitungen zu den Ventilatoren sind über die Tür-/Körperverbindung durch eine trennbare Stecker-/Buchsenverbindung angeschlossen, so dass die Tür als getrennte Einheit hergestellt und für Ersatz oder Reparatur vom Körper getrennt werden kann. Im Betrieb saugen die Ventilatoren Außenluft durch die Platte mit den Luftschlitzen ins Innere der Feststation. Die Außenluft streicht durch den Wärmetauscher und Innenluft aus der Feststation wird ebenfalls durch den Wärmetauscher gesaugt, wobei die Luft die Feststation durch die Platte verlässt, stellt schematisch den Luftstrom dar und zeigt, wie die von außen angesaugte Luft und die Luft aus dem Inneren der Feststation über den Wärmetauscher in eine Wärmeaustauschverbindung gebracht werden. Die Innentemperatur in der Feststation wird also durch das in oder auf der Tür angebrachte Gerät reguliert, jedoch erfolgt auch hier keine Innentemperatursteuerung über die Drehzahlen der Ventilatoren.

Die US-A-3,559,728 betrifft eine in sich geschlossene Kühl- oder Wärmetauscheinheit mit relativ geringer Tiefe zur Ermöglichung der Montage der Einheit außen auf die Wand von Gehäusen und Ähnlichem als Tür des Gehäuses oder als in einem engen Zwischenraum zwischen Gehäusen angeordnete Trennung. Diese Wärmeaustauscheinheit ist mit einer Temperaturreguliereinheit zur Regulierung der Temperatur in einem Gehäuse oder Schrank, das elektronische Apparatur und Ähnliches enthält, versehen, wobei diese Einheit in sich abgeschlossen und insbesondere für die externe Montage auf das Gehäuse geeignet ist; sie umfasst ein Behältnis, das mindestens einen im Wesentlichen hohlen Raum aufweist, der mit dem Gehäuse in Verbindung steht und das eine erste im Wesentlichen flache Oberfläche verfügt, die das Behältnis verschließt und ein erstes Paar vertikal beabstandeter Öffnungen aufweist, die mit dem Hohlraum in Verbindung stehen. Mit dem Behältnis sind Montagemittel zur Montage der Einheit am Äußeren des Gehäuses verbunden, wobei das öffnungspaar mit dem Inneren des Gehäuses in Verbindung steht. Außerdem sind elektrisch betreibbare Luftzirkulationsmittel im Behältnis vorgesehen, die vom Inneren des Gehäuses durch die flache Verschlussfläche isoliert sind und mit dem Hohlraum in dem Behältnis in Verbindung stehen, um eine erzwungene Strömung in dem Gehäuse zu erzeugen, indem sie Luft aus dem Raum durch eine Öffnung des Öffnungspaares in und durch das Gehäuse treiben und dann durch die andere der Öffnungen zurück in den Raum, um die Temperatur der Luft in dem Gehäuse zu regulieren, wobei die flache Oberfläche ebenfalls die elektrische Abschirmung der elektronischen Apparatur in dem Gehäuse von Störungen sicherstellt, die durch den elektronischen Betrieb der Luftzirkulationsmittel entstehen, die zur Regulierung der Gehäusetemperatur verwendet werden.

Die DE-A-37 17 540 offenbart einen innen oder außen an einer Wand oder Tür eines Schaltschrankes anzuordnenden Wärmetauscher, mit einem Gehäuse, in dem ein Wärmetauscheraggregat und dem Aggregat benachbart, zwei in einem inneren bzw. einem äußeren Luftkreislauf liegende Gebläseeinheiten angeordnet sind, wobei dem Wärmetauscheraggregat Lufteinlass- und Luftauslassöffnungen für die geförderte Luft zugeordnet sind. Dieser Wärmetauscher wiest eine in dem inneren Luftkreislauf befindliche Heizvorrichtung auf, um die Bildung von Kondens- und Schwitzwasser zu verbinden, denn wenn die Baugruppen abgeschaltet werden, sinkt die Temperatur im Inneren des Schaltschrankes ab. Dabei kann Kondens- oder Schwitzwasser entstehen. Um das zu vermeiden, wird sobald die Temperatur unter einen vorbestimmten Wert absinkt, die elektrische Energieversorgung der Heizvorrichtung durch eine Steuerungs- oder Regelungseinrichtung eingeschaltet. Diese Steuerungs- oder Regelungseinrichtung ist mit einem im Inneren des Schaltschrankes befindlichen Temperaturfühler ausgestattet. Gleichzeitig ist die Gebläseeinheit des inneren Luftkreislafes in Betrieb, während die Gebläseeinheit des äußeren Luftkreislaufes abgeschaltet ist. Auf diese Weise ist gewährleistbar, dass die Temperatur im Inneren des Schaltschrankes überall und immer über dem Taupunkt liegt.

Die Überschreitung einer Maximaltemperatur kann durch Abschalten der Heizvorrichtung und Kühlung durch das Wärmetauscheraggregat in der oben beschriebenen Weise verhindert werden.

Diese Temperaturregulierungseinheit ermöglicht eine Temperaturregulierung in einem Schaltschrank, die allerdings bauintensiv ist und mit der keine Temperatursteuerung über eine Drehzahlerfassung der Ventilatoren oder Lüfter erfolgt.

Es ist daher Aufgabe der vorliegenden Erfindung, eine Vorrichtung der oben genannten Art zur Verfügung zu stellen, welche Wärme aus einem Gehäuseinnenraum nach außen abtransportiert und die Innentemperatur für die beteiligten Komponenten innerhalb tolerierter Grenzen aufrechterhält.

Diese Aufgabe wird durch eine Vorrichtung der o. g. Art mit den in Anspruch 1 gekennzeichneten Merkmalen gelöst.

Hiernach besteht die erfindungsgemäße Vorrichtung darin, dass die Steuereinrichtung so ausgelegt ist, dass mindestens die wenigstens eine erste Fluidpumpe des ersten Fluidleitungssystems dauernd in dem ersten Drehzahlbereich zwischen 50 % und 100 % läuft und die wenigstens eine zweite Fluidpumpe des zweiten Fluidleitungssystems erst ab einer vorgebbaren Temperatur des Arbeitsfluids mit 50 % des zweiten Drehzahlbereichs läuft und bei maximaler Temperatur des Arbeitsfluids eine maximale Drehzahl von 100 % aufweist, wobei der Wärmetauscherblock außen auf das Gehäuse aufgesetzt ist und Öffnungen zum Fluideinströmen und Fluidausströmen zwischen dem Innenraum des Gehäuses und dem ersten Fluidleistungssystem vorgesehen sind und als Kreuzstromplattentauscher ausgebildet ist, der aus einer Serie von Aluminiumblechen besteht, deren Ecken abwechselnd zur Formung von zwei Satz enge Luftpassagen verpresst sind.

Dies hat den Vorteil, dass die Wärme indirekt abgeführt wird, also ohne Entnahme von Fluid aus dem Gehäuseinnenraum und ohne Vermischung von Fluid im Gehäuseinnenraum, dem ersten Arbeitsfluid, und dem zweiten Arbeitsfluid. Daher ist die erfindungsgemäße Vorrichtung insbesondere bei isolierten, luftdichten bzw. hermetisch abgeschlossenen Gehäusen anwendbar. Durch die Anordnung des Wärmetauscherblockes an der Außenwand des Gehäuses wird eine wartungsfreudige Anordnung geschaffen. Der Kreuzstromwärmetauscher ermöglicht eine leichte Reinigung des externen Luftweges.

Vorzugsweise Weitergestaltungen der Vorrichtung sind in den Unteransprüchen beschrieben.

Zweckmäßigerweise ist das erste und/oder zweite Arbeitsfluid Luft und vorzugsweise sind die Fluidpumpen Ventilatoren, insbesondere Radialventilatoren, Axialventilatoren oder Tangentialventilatoren.

Diese Steuereinrichtung weist in besonders bevorzugter Weise zusätzlich einen Störmeldeausgang auf.

Zweckmäßigerweise ist das Gehäuse luftdicht, insbesondere hermetisch, bezüglich der Umgebung abgeschlossen.

Zur Vermeidung des Unterschreitens eines Taupunktes wenigstens eines Arbeitsfluides ist in einer besonders bevorzugten Ausführungsform zusätzlich eine Heizeinrichtung, insbesondere ein Widerstandsheizelement, vorgesehen.

Nachstehend wird die Erfindung anhand der beigefügten Zeichnungen näher erläutert. Diese zeigen in
- Fig. 1: eine Ausführungsform einer Vorrichtung zm Austausch von Wärmeenergie in einer schaubildlichen Darstellung,
- Fig. 2: eine Ausführungsform der Vorrichtung in einer Schnittansicht,
- Fig. 3: in einer Seitenansicht in Richtung des Pfeiles B in Figur 2, die Vorrichtung,
- Fig. 4: in einer Draufsicht, die Vorrichtung,
- Fig. 5: in einer Rückansicht die Vorrichtung und
- Fig. 6: in einer weiteren Seitenansicht in Richtung des Pfeiles A in Fig. 2, die Vorrichtung.

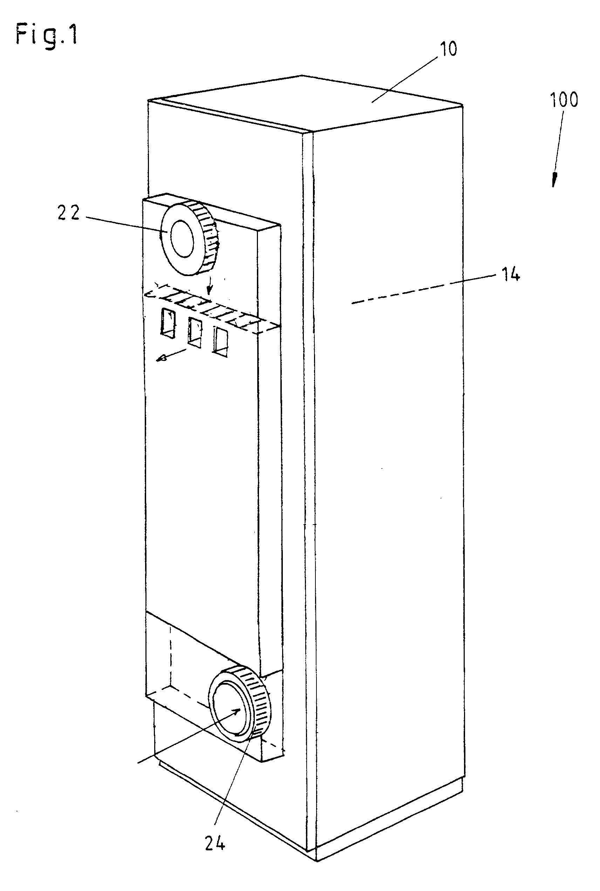

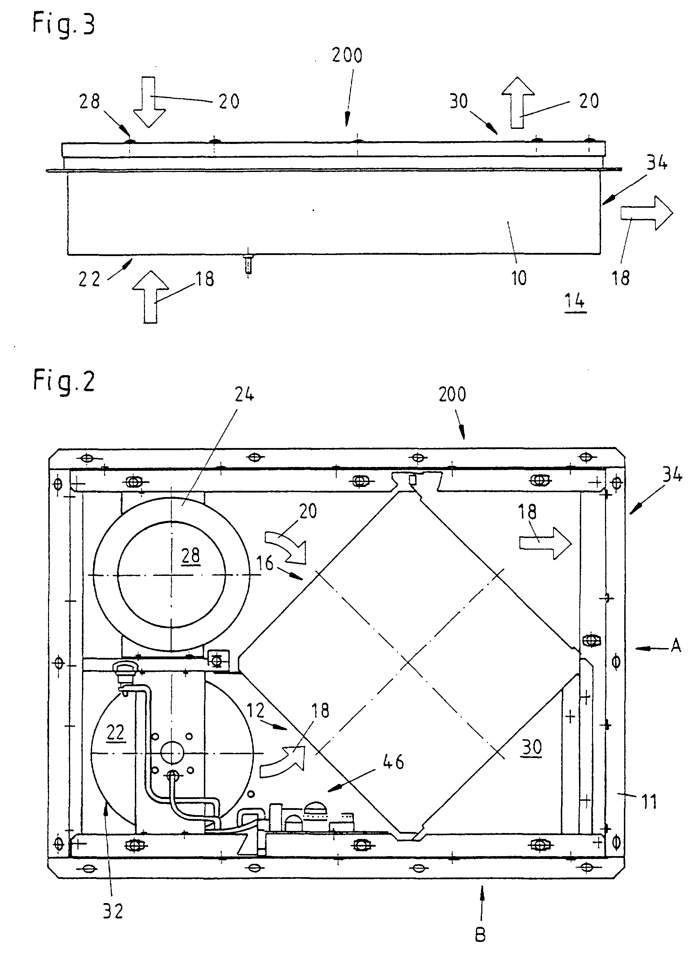

Die in Fig. 1 dargestellte Ausführungsform einer Vorrichtung 100 umfaßt ein Gehäuse 10 und einen Wärmetauscherblock 11 mit einem ersten Fluidleitungssystem 12 als Innenkreislauf (Fig. 2), welches mit einem Innenraum 14 des Gehäuses 10 in Verbindung steht, und einem zweiten Fluidleitungssystem 16 als Außenkreislauf, welches mit einer Umgebung in Verbindung steht. In den Fluidleitungssystemen 12, 16, wird jeweils Luft als Arbeitsfluid 18, 20 von Fluidpumpen 22 und 24 in Form von inneren und äußeren Radialventilatoren umgewälzt (Fig. 3). Hierbei fördert die Fluidpumpe 22 die Luft 18 im Innenraum 14 des Gehäuses 10 durch das erste Fluidleitungssystem 12 und die Fluidpumpe 24 die Außenluft jeweils durch das zweite Fluidleitungssystem 16.

Der Wärmetauscherblock 11 ist als Gegenstromplattentauscher ausgebildet und sorgt für einen Wärmeaustausch zwischen der Luft 18 im Innenraum 14 des Gehäuses 10 und der Luft 20 der Umgebung, so daß Wärmeenergie aus dem Innenraum 14 nach Außen abtransportiert wird.

Die Fig. 2 bis 6 zeigen eine weitere Ausführungsform der Vorrichtung 200. Hierbei ist, wie insbesondere aus Fig. 2 ersichtlich, der Wärmetauscherblock 11 als Kreuzplattenwärmetauscher ausgebildet. Kalte Umgebungsluft 20 dringt in das zweite Fluidleitungssystem 16 des Wärmetauscherblockes 11 über ein Öffnung 28 ein und tritt über eine Öffnung 30 aufgewärmt wieder aus, wogegen warme Innenraumluft 18 des Gehäuses 10 über eine Öffnung 32 in das erste Fluidleitungssystem 12 des Wärmetauscherblockes 11 eintritt und über eine Öffnung 34 gekühlt wieder austritt.

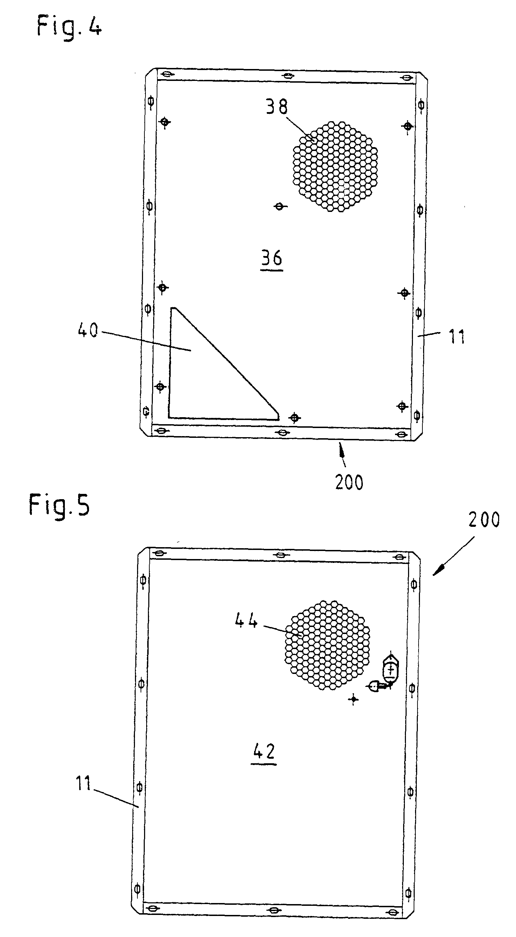

Ein Bodenteil 36 mit entsprechenden Öffnungen 38 und 40 für den Lufteinlaß 28 und Luftauslaß 30 der Umgebungsluft 20 ist in Fig. 4 dargestellt. Ein Deckelteil 42 mit einer entsprechenden Öffnung 44 für den Lufteinlaß 32 der Umgebungsluft 18 ist aus Fig. 5 ersichtlich.

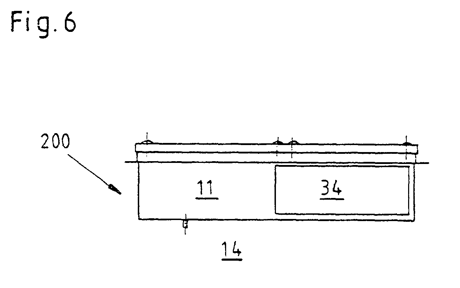

Die Fig. 3 und 6 veranschaulichen das Ein- und Ausströmen der Umgebungsluft 20 und Innenraumluft 18 in den Wärmetauscherblock 11 hinein bzw. aus diesem heraus über Öffnungen 28, 30, 32 und 34.

Wie sich aus Fig. 2 ergibt, ist im ersten Fluidleitungssystem 12 eine Steuereinrichtung 46 vorgesehen. Diese nimmt die Temperatur der Innenraumluft 18 auf und bestimmt gemäß diesem Wert eine Drehzahl der Fluidpumpe 22 derart, daß eine maximale Innenraumtemperatur im Gehäuse nicht überschritten wird.

Die Verwendung von Aluminium hat dabei folgende Vorteile:
- Durch das Konstruktionsprinzip der Einrichtung ist ein einfacher Ein- und Ausbau aller Komponenten (insbesondere Tauscherblock 11 und Fluidpumpen 22, 24) möglich; dies ist besonders servicefreundlich.
- Die durchgängige Ausführung des Gehäuses und Wärmetauschers in Aluminium führt zu einem korrosionsbeständigem Endgerät.

Der Wärmeaustauscherblock 11 ist aus einer Serie von Aluminiumblechen gefertigt; die Ecken sind abwechselnd verpreßt um 2 Satz enge Luftpassagen zu formen, einmal für die Außenluft 20 und einmal für die zirkulierende Luft 18. Der warme Luftstrom 18 gibt Wärme an den Kaltluftstrom 20 ab, jedoch ohne daß sich die Luftströme ver-mischen.

Die mechanischen Daten des Wärmeaustauscherblocks bei einer beispielhaften Ausführungsform sind folgende:

| | |
|---|---|
| Abmessungen | 300 x 300 x 120 mm |
| Gewicht | 5,0 KG |
| Blechabstand | 3 mm |
| Blechstärke | 0,4 mm |
| Anzahl der Kanäle | 19 |

Die Fluidpumpen 22, 24 befinden sich oben rechts und links an dem Wärmetauscherblock 11 gemäß Fig. 2. Es handelt sich um Radialventilatoren, die beispielsweise von kollektorlosen 48 V DC Motoren angetrieben werden. Die Motore sind drehzahlgeregelt über Pulsbreitenmodulation und werden drehzahlüberwacht (Hallgenerator). Die Fluidpumpe 22 läuft dauernd zwischen 50 % minimum und 100 % bei maximaler Innentemperatur. Die Fluidpumpe 24 läuft ab 35 °C Innentemperatur mit 50 % Drehzahl und geht bis auf 100 % bei maximaler Innentemperatur. Die Motoren sind drehzahlgeregelt über Pulsbreitenmodulation bei 48V DC und Phasenausschnittregelung bei 230V AC.

Für die Dimensionierung ergibt sich folgendes Beispiel:

| | |
|---|---|
| Ventilatorrad | 190mm ∅ |
| Luftfördermenge | 300 m³/h |
| Ext. statischer Druck | 100 Pa |
| Spannung | 48 V DC |
| Leistungsaufnahme | 62 Watt |
| Vollaststrom | 1,3 Amp |
| Anlaufstromaufnahme | 4 Amp |

Die o. g. Spezifikationen gelten beispielhaft für Außen- und Innenlüfter.

Optimal ist eine externe Heizung vorgesehen, die bei 7 °C von einer Kontrolleinheit aus aktiviert wird.

Ein verwendetes Kontrollsystem beinhaltet eine Platine mit folgenden Anschlüssen:.

Drehzahlkontrolle für die Fluidpumpen 22, 24 durch einen Temperatursensor auf der Platine; Anschlüsse für 2 Fluidpumpen und einem 48 V Ausgang für ein externes Heizungsrelais Anschluß für ein Alarmsignal (Störungslüfter) und Übertemperatur: potentialfreie Kontakte.

Der Temperaturfühler mißt die Temperatur der zurückgeführten Luft 18 und paßt die Geschwindigkeiten der Fluidpumpen 22, 24 entsprechend an. Der Sollwert ist beispielsweise 45 °C. Die Fluidpumpe 22 startet bei ca. 35 °C und erreicht die höchste Drehzahl beim Sollwert.

Die Alarmtemperatur liegt beispielsweise bei 48 °C. Bei Lüfterstörung oder Temperaturalarm wird ein potentialfreier Kontakt betätigt, der extern weiterverarbeitet werden kann.

Es ergibt sich dabei folgende Steuertabelle:

| | | | | | | | | | |
|---|---|---|---|---|---|---|---|---|---|
| Temp. °C | <0°-5° | 5°-7° | 7°-25° | 25°-30° | 30°-35° | 35°-40° | 40°-43° | 43°-48° | >60° |
| Lüf-ter 50 % | 60 % | 60 % | 60 % | 70 % | 80 % | 80 % | 100 % | 100 % | 100% |
| Lüfter | off | Off | off | off | Off | 50 % | 70 % | 100 % | 100% |
| alarm Temp. | off | Off | off | off | Off | off | off | off | on |
| Heizer | on | On | off | off | Off | off | off | off | off |

Die Hauptdaten der Vorrichtung sind beispielhaft wie folgt:

| | |
|---|---|
| Abmessungen | 460 x 640 × 130 mm |
| Gewicht | 14 kg |
| Betriebstemperatur | - 35 °C bis + 60 °C |
| Max. Innentemperatur | 55 °C |
| Max. Außentemperatur | 40 °C |
| Max. Wärmeentzugsrate | 64 W/K |
| Spannung | 48 V DC |
| Leistungsaufnahme | 124 Watt |
| Vollaststrom | 2,6 Amp |
| Anlaufstromaufnahme | 6 Amp |

Eine Wartung der Vorrichtung erfolgt beispielsweise folgendermaßen:
1. Reinigen der Lüfter:
   Staub der sich auf die Ventilatoren der Fluidpumpen 22, 24 (insbesondere bei der Fluidpumpe 24) setzt, muß beispielsweise alle 6 Monate entfernt werden um einen einwandfreien Betrieb zu gewährleisten sowie um Vibration zu vermeiden, die zu Lagerschäden führt und die Lebensdauer der Fluidpumpen reduziert. Den Ventilator mit Preßluft oder in speziellen Fällen mit einer Bürste und einem pH neutralen Seifenwasser reinigen (nur den Außenlüfter). Ablagerungen auf dem inneren Lüfter bedeuten, daß der Schaltschrank oder das Gehäuse 10 undicht sind. Hierzu bedarf es weiterer Maßnahmen.
2. Reinigen des Wärmeaustauscherblocks 11
   Staub der sich auf den Wärmeaustauscherblock 11 (speziell im äußeren Lüfterkreis 16) setzt, muß beispielsweise alle 6 Monate entfernt werden, um einen einwandfreien Betrieb zu gewährleisten. Der Wärmeaustauscherblock 11 ist mit Preßluft oder in speziellen Fällen mit einer pH neutralen Seifenlösung, die mit Preßluft aufgesprüht wird zu reinigen (nur beim äußeren Luftkreis 16). Den Lüfter sollte man nicht mit Wasser besprühen und nur den äußeren Luftkreis des Wärmeaustauscherblocks ist zu reinigen. Wenn Preßluft oder Sprühwasser benutzt wird, achte man darauf, daß die Dichtungen nicht beschädigt werden.

Bei bestimmten Komponenten kann es vorkommen, daß sie während der Lebenszeit des Gerätes ausgetauscht werden müssen. Folgende Abläufe sind zu beachten, wenn Ersatzteile ausgewechselt werden.

Vor Wartungsarbeiten ist das PLL stromlos zu schalten.
1. Allgemeines
   Die Lüfter, die Platine und der Wärmeaustauscherblock können nach Abnahme der Haube leicht erreicht werden.
2. Kontrolleinheit (Platine)
   Klemme alle Kabel ab. Entferne die 4 Schrauben, die die Platine halten. Entferne die Platine. Klemme wieder alle Kabel an und setze die neue Platine ein. Prüfe, daß korrekt angeschlossen wurde (siehe Anschlußdiagramm). Vergewissern, daß an den Lüftern keine Kabel anliegen.
3. Innere Lüfter (DC Lüfter)
   Klemme die Kabel von der Platine ab. Entferne die 4 Schrauben die den Lüfterträger halten, entferne die 4 Schrauben auf der Rückseite des Lüfterträgers, entferne den Lüfter. Neuen Lüfter einsetzen, Schrauben in umgedrehter Reihenfolge wie vorgenannt anbringen, Kabel anschließen. Prüfe, daß korrekt angeschlossen wurde (siehe Anschlußdiagramm) und daß keine Kabel am Lüfter anliegen.
4. Äußerer Lüfter (DC Lüfter)
   wie oben - Innerer Lüfter
5. Wärmeaustauscherblock
   Die Spannvorrichtung, die sich am Trennblech zwischen den beiden Lüftern befindet, lösen und den Tauscherblock 11 herausnehmen. Überprüfen der Dichtungen! Dann den neuen Block 11 einsetzen und spannen.

## Patentansprüche

1. Vorrichtung zum Austausch von Wärmeenergie zwischen einem Innenraum (14) eines Gehäuses (10), insbesondere für ein Telekommunikationsgerät, und einer Umgebung, umfassend einen Wärmeaustauscherblock (11) mit wenigstens zwei voneinander getrennten und miteinander in wärmeenergieübertragenden Kontakt stehenden Fluidleitungssystemen (12, 16), wobei ein erstes Fluidleitungssystem (12) mit einem Gehäuseinnenraum (14) und ein zweites Fluidleitungssystem (16) mit der Umgebung verbunden ist und jedem Fluidleitungssystem (12, 16) jeweils wenigstens eine Fluidpumpe (22, 24) zum Fördern eines ersten Arbeitsfluids (18) im ersten Fluidleitungssystem (12) und eines zweiten Arbeitsfluids (20) im zweiten Fluidleitungssystem (16) zugeordnet ist, wobei im Innenraum (14) des isolierten, luftdichten bzw. hermetisch abgeschlossenen Gehäuses (10) oder im ersten Fluidleitungssystem eine Steuereinrichtung (46) vorgesehen ist, wobei mittels der Steuereinrichtung (46) mindestens ein erster Drehzahlbereich der wenigstens einen ersten Fluidpumpe (22) des ersten Fluidleitungssystems (12) und zusätzlich ein zweiter Drehzahlbereich der wenigstens einen zweiten Fluidpumpe (24) des zweiten Fluidleitungssystems (16) beeinflussbar ist, wobei der Steuereinrichtung (46) ein gemessener Wert einer Temperatur des ersten Arbeitsfluids (18) zuführbar ist und eine erste Drehzahl des mindestens einen ersten Drehzahlbereiches der wenigstens einen ersten Fluidpumpe (22) und zusätzlich eine zweite Drehzahl des zweiten Drehzahlbereiches der wenigstens einen zweiten Fluidpumpe (24) gemäß diesem Temperaturwert steuerbar ist, **dadurch gekennzeichnet, dass** die Steuereinrichtung (46) so ausgelegt ist, dass mindestens die wenigstens eine erste Fluidpumpe (22) des ersten Fluidleitungssystems (12) dauernd in dem ersten Drehzahlbereich zwischen 50 % und 100 % läuft und die wenigstens eine zweite Fluidpumpe (24) des zweiten Fluidleitungssystems erst ab einer vorgebbaren Temperatur des Arbeitsfluids (18) mit 50 % des zweiten Drehzahlbereiches läuft und bei maximaler Temperatur des Arbeitsfluids (18) eine maximale Drehzahl von 100 % aufweist, und dass der Wärmetauscherblock (11) außen auf das Gehäuse (10) aufgesetzt ist und Öffnungen (32, 34) zum Fluideinströmen und Fluidausströmen zwischen dem Innenraum (14) des Gehäuses (10) und dem ersten Fluidleitungssystem (12) vorgesehen sind und als Kreuzstromplattentauscher ausgebildet ist, der aus einer Serie von Aluminiumblechen besteht, deren Ecken abwechselnd zur Formung von zwei Satz enge Luftpassagen verpresst sind.

2. Vorrichtung nach Anspruch 1,
**dadurch gekennzeichnet,**
**dass** das erste und/oder zweite Arbeitsfluid (18, 20) Luft ist.

3. Vorrichtung (100, 200) nach Anspruch 1 oder 2,
**dadurch gekennzeichnet,**
**dass** die Fluidpumpen (22, 24) Ventilatoren, insbesondere Radialventilatoren, Axialventilatoren oder Tangentialventilatoren sind.

4. Vorrichtung nach einem der Ansprüche 1 bis 3,
**dadurch gekennzeichnet,**
**dass** die Steuereinrichtung (46) einen Störmeldeausgang aufweist.

5. Vorrichtung nach einem der Ansprüche 1 bis 4,
**dadurch gekennzeichnet,**
**dass** das Gehäuse (10) luftdicht, insbesondere hermetisch, bezüglich der Umgebung abgeschlossen ist.

6. Vorrichtung nach einem der Ansprüche 1 bis 5,
**dadurch gekennzeichnet,**
**dass** zusätzlich eine Heizeinrichtung, insbesondere ein Widerstandsheizelement, vorgesehen ist.

## Claims

1. Device for the exchange of heat energy between the inside (14) of a housing (10), in particular for a telecommunication device, and the environment, comprising a heat exchanger block (11) with at least two fluid conduction systems (12, 16) separated from each other and in heat energy transmitting contact, whereby a first fluid conduction system (12) is connected with a housing inside (14) and a second fluid conduction system (16) is connected with the environment and at least one fluid pump (22, 24) for the delivery of a first working fluid (18) in the first fluid conduction system (12) and of a second working fluid (20) in the second fluid conduction system (16) is associated respectively to each fluid conduction system (12, 16), whereby a control device (46) is provided in the inside (14) of the insulated air tightly or hermetically sealed housing (10) or in the first fluid conduction system, whereby at least a first rpm range of the at least first fluid pump (22) of the first fluid conduction system (12) and additionally a second rpm range of the at least second fluid pump (24) of the second fluid conduction system (16) is influenceable by means of the control device (46), whereby a measured value of a temperature of the first working fluid (18) can be fed to the control device (46) and a first rpm of the at least one rpm range of the at least first fluid pump (22) and additionally a second rpm of the second rpm range of the at least second fluid pump (24) is controllable according to this temperature value, **characterized in that** the control device (46) is dimensioned such that at least the at least first fluid pump (22) of the first fluid conduction system (12) continuously runs in the first rpm range between 50 % and 100 % and the at least second fluid pump (24) of the second fluid conduction sytem runs only from a temperature of the working fluid (18) on which can be preset with 50 % of the second rpm range and has a maximal rpm of 100 % for a maximal temperature of the working fluid (18) and that the heat exchanger block (11) is placed outside on the housing (10) and openings (32, 34) for the fluid admission and fluid discharge between the inside (14) of the housing (10) and the first fluid conduction system (12) are provided and that the heat exchanger block is configured as countercurrent plate exchanger which is made of a series of aluminium sheets, the corners of which are pressed alternately for forming two groups of narrow air passages.

2. Device according to claim 1,
**characterized in**
**that** the first and/or second working fluid (18, 20) is air.

3. Device (100, 200) according to claim 1 or 2,
**characterized in**
**that** the fluid pumps (22, 24) are fans, in particular radial fans, axial fans or tangential fans.

4. Device according to any of the claims 1 to 3,
**characterized in**
**that** the control device (46) has a fault message output.

5. Device according to any of the claims 1 to 4,
**characterized in**
**that** the housing (10) is air-tightly sealed, in particular hermetically sealed, with respect to the environment.

6. Device according to any of the claims 1 to 5,
**characterized in**
**that** additionally a heating device, in particular a resistance heating element, is provided.

## Revendications

1. Dispositif pour l'échange d'énergie thermique entre l'intérieur (14) d'un boîtier (10), en particulier pour un appareil de télécommunication, et un environnement, comprenant un bloc d'échangeurs de chaleur (11) avec au moins deux systèmes de conduction de fluide (12, 16) séparés l'un de l'autre et étant en contact de transmission d'énergie thermique l'un avec l'autre, un premier système de conduction de fluide (12) étant relié à un intérieur de boîtier (14) et un second système de conduction de fluide (16) étant relié à l'environnement et au moins une pompe de fluide (22, 24) pour refouler un premier fluide de travail (18) dans un premier système de conduction de fluide (12) et d'un second fluide de travail (20) dans le second système de conduction de fluide (16) correspondant respectivement à chaque système de conduction de fluide (12, 16), un dispositif de contrôle (46) étant prévu dans l'espace intérieur (14) du boîtier (10) isolé, fermé étanche à l'air ou hermétiquement ou dans le premier système de conduction de fluide, au moins un premier régime de vitesse de rotation de la première pompe de fluide (22) qui existe au moins du premier système de conduction de fluide (12) et en plus un second régime de vitesse de rotation de la seconde pompe de rotation qui existe au moins (24) du second système de conduction de fluide (16) étant influençable au moyen du dispositif de contrôle (46), une valeur mesurée d'une température du premier fluide de travail (18) pouvant être amenée au dispositif de commande (46) ou une première vitesse de rotation du premier régime de vitesse de rotation qui existe au moins pouvant être amenée au dispositif de commande (46) et de plus une seconde vitesse de rotation du second régime de vitesse de rotation de la seconde pompe de fluide (24) qui existe au moins pouvant être commandée selon cette valeur de température, **caractérisé en ce que** le dispositif de commande (46) est conçu de telle manière qu'au moins la première pompe de fluide (22) qui existe du premier système de conduction de fluide (12) marche en continu dans le premier régime de vitesse de rotation entre 50 % et 100 % et la seconde pompe de fluide (24) du second système de conduction de fluide ne marche qu'à partir d'une température du fluide de travail (18) qui peut être prédéfinie avec 50 % du second régime de vitesse de rotation et présente une vitesse de rotation maximale de 100 % pour une température maximale du fluide de travail (18) et que le bloc d'échangeurs de chaleur (11) est posé à l'extérieur sur le boîtier (10) et que des ouvertures (32, 34) pour l'admission et l'évacuation du fluide entre l'espace intérieur (14) du boîtier (10) et le premier système de conduction de fluide (12) sont prévues et que le bloc est configuré comme un échangeur de chaleur à plaques à courants inversés qui est constitué par une série de tôles d'aluminium dont les coins sont comprimés en alternance pour former deux ensembles de passages d'air étroits.

2. Dispositif selon la revendication 1,
**caractérisé en ce**
**que** le premier et/ou le second fluide de travail (18, 20) est de l'air.

3. Dispositif (100, 200) selon la revendication 1 ou 2,
**caractérisé en ce**
**que** les pompes de fluide (22, 24) sont des ventilateurs, en particulier des ventilateurs radiaux, des ventilateurs axiaux ou des ventilateurs tangentiels.

4. Dispositif selon l'une des revendications 1 à 3,
**caractérisé en ce**
**que** le dispositif de contrôle (46) présente une sortie d'information d'anomalie.

5. Dispositif selon l'une des revendications 1 à 4,
**caractérisé en ce**
**que** le boîtier (10) est fermé étanche à l'air, en particulier hermétiquement, par rapport à l'environnement.

6. Dispositif selon l'une des revendications 1 à 5,
**caractérisé en ce**
**qu'**il est prévu de plus un dispositif de chauffage, en particulier un élément de chauffage à résistance.
